# EUROPÄISCHE PATENTSCHRIFT

(11) **EP 1 909 115 B1**
(45) Veröffentlichungstag und Bekanntmachung des Hinweises auf die Patenterteilung: **04.03.2009**
(21) Anmeldenummer: 07115795.2
(22) Anmeldetag: 06.09.2007
(51) Int. Cl.: G01S 17/36, G01S 7/484, G01S 7/491

(54) **Erzeugung eines Signals mit vorgegebener Phase auf einem programmierbaren Baustein und darauf basierende Entfernungsmessung**
Signal generation with predefined phase on a programmed chip and distance measurement based thereon
Production d'un signal doté d'une phase prédéterminée sur un module programmable et mesure d'éloignement basée sur celle-ci

(30) Priorität: 06.10.2006 DE 102006047778; 14.10.2006 DE 102006048697
(43) Veröffentlichungstag der Anmeldung: 09.04.2008
(73) Patentinhaber: SICK AG, 79183 Waldkirch (DE)
(72) Erfinder: Hug, Gottfried, 79183, Waldkirch (DE); Heizmann, Reinhard, 79286, Glottertal (DE)
(74) Vertreter: Ludewigt, Christoph

(56) Entgegenhaltungen:
- WO-A-02/44754
- US-A- 5 745 442
- US-A1- 2005 168 721

## Beschreibung

Die Erfindung betrifft eine Vorrichtung und ein Verfahren zur Erzeugung eines periodischen elektrischen Signals mit vorgegebener Phasenverschiebung gegenüber einem Referenzzeitpunkt sowie eine darauf basierende Entfernungsmessung.

Die Entfernung eines Objekts kann optisch nach dem Prinzip des Laufzeitverfahrens bestimmt werden. Dazu kann einem Lichtstrahl ein Sendemuster aufgeprägt werden, das bei Empfang des von dem Objekt reflektierten Lichts mit einem intern erzeugten Referenzmuster verglichen wird. Daraus lässt sich der Lichtweg und damit auch der Abstand errechnen. In der Praxis werden im Wesentlichen zwei Verfahren angewandt. Bei dem einen Verfahren ist das Sendemuster ein einfacher Lichtpuls, dessen Laufzeit gemessen wird. Bei dem anderen Verfahren ist das Sendemuster eine Sinusmodulation, wobei die Phasenlage des Sinus gegenüber einem Referenzsinus modulo der Periode des Sinus der Laufzeit entspricht.

Die Entfernungsmessung kann beispielsweise in der Fahrzeugsicherheit, der Logistikautomatisierung oder der Sicherheitstechnik benötigt werden. Insbesondere kann ein Entfernungsmesser, der auf einem reflektierten Lichtstrahl basiert, auf eine Entfernungsänderung des Reflektors oder des reflektierenden oder remittierenden Ziels reagieren.

Bei dem hier betrachteten Messverfahren der Lichtlaufzeit gibt es zwei Signalpfade. Auf dem internen Referenzpfad gibt es keinen Lichtweg, die Laufzeit hängt also auch nicht von der Entfernung des Objekts ab. Auf dem externen Messpfad addiert sich zu einer internen Laufzeitkomponente die distanzabhängige externe Laufzeitkomponente des Lichtes.

Um die Lichtlaufzeit präzise bestimmen zu können, müssen die Phasenlagen von Sendemuster und Referenzmuster sehr genau aufeinander abgestimmt sein. Die Entfernungsgenauigkeit bzw. die Auflösung hängt also direkt von einer feinstufigen Einstellung der Verzögerungszeit des Sendemusters ab.

Im Stand der Technik wird als Messkern ein ASIC eingesetzt, der diskrete Verzögerungsschritte über eine geregelte Delay Locked Loop (DLL) erzeugt. Das zentrale Element einer solchen DLL ist eine Kette aus Verzögerungselementen, von denen die benötigte Anzahl für eine vorgegebene Verzögerung abgegriffen wird. Ein festverdrahteter ASIC ist aber vergleichsweise teuer, nur zeit- und kostenintensiv zu entwickeln und kann nur unter erneutem hohem Entwicklungsaufwand verändert werden.

Aus der Digitaltechnik ist die direkte digitale Synthese (DDS) bekannt. Damit lassen sich digitale Signale einer vorgegebenen Frequenz und Phasenlage erzeugen. Solche digitalen Bausteine sind, wenn sie die nötige Präzision aufweisen sollen, aber vergleichsweise teuer. Die US 2005/0168721 A1 beschreibt einen Laserentfernungsmesser, in dem eine DDS Pulsfrequenzen erzeugt, welche Zeiteinheiten für die Lichtlaufzeitmessung entsprechen, wobei in jede Entfernungsmessung mindestens zwei unterschiedliche Zeiteinheiten einfließen.

Aus der WO 02/44754 A1 ist ein Verfahren zur Frequenzsynthese für einen Entfernungsmesser bekannt. Dabei wird mit einem niederfrequenten Signal die Phasenverschiebung ausgesandter elektromagnetischer Strahlung zu einer Referenz bestimmt. Dazu wird ein Ringoszillator auf eine Modulationsfrequenz abgestimmt, und das Signal mehreren Verzögerungsstufen des Ringoszillators wird einem Multiplexer zugeführt, der ein um die niedrige Frequenz von der Modulationsfrequenz verschiedene Mischerfrequenz erzeugt.

Der Erfindung liegt daher die Aufgabe zugrunde, mit einfachen, flexiblen und kostengünstigen Mitteln ein Signal mit einstellbarer Verzögerung bei hoher zeitlicher Präzision zu erzeugen.

Diese Aufgabe wird durch eine Vorrichtung gemäß Anspruch 1 und ein Verfahren gemäß Anspruch 14 gelöst. Die Lösung hat den Vorteil, dass kein eigener teurer Baustein für direkte digitale Synthese (DDS) benutzt werden muss. Damit kann ein kostengünstiger, genauer und zuverlässiger Messkern hergestellt werden.

Für die Lösung war also zunächst die Idee entscheidend, DDS zu verwenden, obwohl sie eigentlich in die digitale Welt gehört und die Anforderungen an einen flexiblen, kostengünstigen Baustein gar nicht erfüllt. Eine programmierbare Logik, mittels derer die DDS erfindungsgemäß implementiert ist, bringt aber die erforderliche zeitliche Präzision nicht mit. Geht man von einer üblichen Frequenz von 100-400 MHz auf der programmierbaren Logik aus, so entspricht das gerade einer Zeitauflösung von 2,5-10ns, die den Anforderungen an die präzise Entfernungsmessung bei weitem nicht genügt. Das funktioniert erst mit dem kennzeichnenden Merkmal der Erfindung, bei der die Präzision der Phasenlage in der Amplitudeninformation störungsfrei codiert ist.

Vorteilhafterweise ist ein dem Filter nachgeschalteter Binarisierer dafür ausgebildet, das Signal in eine phasengleiche Rechteckschwingung umzuwandeln. Die Rechteckschwingung enthält die hauptsächlich interessante Phase in besonders leicht abzugreifender Form und kann ihrerseits als Taktgeber mit der gewünschten Phasenlage dienen.

Bevorzugt ist ein Sendemustergenerator des Bausteins vorgesehen, der ein zu der Rechteckschwingung phasengleiches Sendemustersignal erzeugen kann. Das Sendemustersignal hat die wohldefinierte Phase, kann aber darüber hinaus in jeder Periode spezifische Informationen enthalten, die eine Identifizierung dieser Periode ermöglicht und damit eine Phasenlage letztlich über eine Periode hinaus definierbar macht.

Vorteilhafterweise ist ein Referenzsignalgenerator des Bausteins vorgesehen, der von dem Referenzzeitpunkt ausgelöst ein Referenzsignal erzeugen kann. Das Referenzsignal dient der Bestimmung der Phasenlage. Noch bevorzugter ist es mit Blick auf das Sendemuster gewählt, um die Identifizierung der Periode zu vereinfachen.

Dabei ist bevorzugt eine Leerschleife aus dem Baustein geführt, über den der Referenzzeitpunkt das Referenzsignal auslöst. Dadurch kann die Signallaufzeit im Referenz- und im Messpfad einander angepasst werden. Vor allem ergibt sich eine gleiche Temperaturabhängigkeit, da beide Pfade über Aus- und Eingänge des Bausteins und über dieselbe Platine geführt sind, so dass die Temperaturstabilität des Messergebnisses verbessert wird.

Vorteilhafterweise weist der Signalgenerator einen Multiplexer auf, an dessen Selecteingängen fest ein auf einem aus der Tabelle ausgelesenen Wert basierendes Bitmuster anliegt und dessen Dateneingänge mit je einem um eine Phase verschobenen Takt des Logikbaussteins verbunden sind, um somit die Abtastrate gegenüber einem Arbeitstakt des Bausteins 1 zu erhöhen. Da die ausgelesenen Werte aus der Tabelle fest an den Dateneingängen anstehen, ist die Signalerzeugung unabhängig von der Auslesegeschwindigkeit des Speichers, in dem die Tabelle abgelegt ist.

Bevorzugt sind alle oder höherwertige Ausgangsbits der Digitale-Synthese-Einrichtung linear codiert. Damit wirken sich Ausgangsfehler weniger aus als bei der binären Codierung.

Bevorzugt sind der Digital-Analog-Wandler, der Filter und der Baustein (bzw. dessen A/D-Wandler) differentiell, insbesondere zweikanalig und gegenphasig gekoppelt und ausgeführt. Das verbessert die Signalqualität und damit die Zuverlässigkeit, wobei sich durch die gegenphasige Ausführung ein äußerer Beitrag kompensiert.

Vorteilhafterweise sind unbenutzte Anschlüsse des Bausteins im Betrieb als Ausgang programmiert und mit externem Potential beschaltet. Noch bevorzugter sind sie als niederohmige LVCMOS-Ausgänge programmiert und beschaltet. Dadurch machen sie die Verbindung zur externen Spannungsversorgung wegen der erhöhten Parallelität niederohmig, so dass ein störendes Signalübersprechen besonders beim Ziehen von Strom aus der externen Stromversorgung deutlich reduziert sind. Dies reduziert Störterme und ermöglicht eine hohe Auflösung.

Bevorzugt weist der Digital-Analog-Wandler ein Widerstandsnetzwerk auf, das von den Strömen der verbundenen Ausgänge des Bausteins getrieben werden kann. Das ist eine extrem einfache und kostengünstige Implementierung eines Digital-Analog-Wandlers, der die Ausgänge des programmierbaren Bausteins für die direkte digitale Synthese vorteilhaft ausnutzt.

In einer weiteren bevorzugten Ausführungsform ist die Vorrichtung in einem optoelektronischen Entfernungsmesser vorgesehen, wobei der Entfernungsmesser mindestens eine modulierbare Lichtquelle aufweist, die für ein Aufprägen des Sendemustersignals auf das Sendelicht ausgebildet ist, sowie mindestens eine Empfangseinheit für reflektiertes Sendelicht, die für ein Rückumwandeln des Sendemustersignals aus dem reflektierten Sendelicht ausgebildet ist, wobei eine Vergleichseinheit für das Erkennen einer gleichen Phasenlage und/oder des Vorzeichens einer abweichenden Phasenlage zwischen dem empfangenen Sendemustersignal und dem Referenzsignal ausgebildet ist. Aus der Änderung und der Änderungsrichtung der Phasenlage lässt sich unmittelbar ablesen, ob und in welcher Richtung sich die Objektentfernung verändert. Selbst noch eine geringfügige Manipulation des reflektierenden Zielobjekts wird sofort erkannt.

Bevorzugt ist dabei eine Phasenabgleichseinheit dafür ausgebildet, verschiedene Tabellenwerte der Tabelle zu durchfahren, um diejenige Phasenverschiebung zu finden, bei der die Vergleichseinheit die beste Übereinstimmung der Phasenlage erkennt. Dies kann zur Entfernungsbestimmung - also absolut und nicht nur einer Veränderung der Entfernung - oder zum Einlernen eines durch den Entfernungsmesser zu überwachenden reflektierenden Zielobjektes dienen.

Noch bevorzugter weist die Tabelle einen Speicher auf, in dem eine Information abgelegt werden kann, bei welchem Tabellenwert die Übereinstimmung der Phasenlage am besten ist. Damit kann eine Objektentfernung, gerade eines zu überwachenden Objektes, gemerkt werden.

Das erfindungsgemäße Verfahren kann auf ähnliche Weise durch weitere Merkmale ausgestaltet werden und zeigt dabei ähnliche Vorteile. Derartige weitere Merkmale sind beispielhaft, aber nicht abschließend, in den sich anschließenden Unteransprüchen beschrieben.

Die Erfindung wird nachstehend auch hinsichtlich weiterer Vorteile und Merkmale unter Bezugnahme auf die beigefügte Zeichnung anhand von Ausführungsbeispielen erläutert. Die Figuren der Zeichnung zeigen in:
- Fig. 1: eine schematische Übersicht über eine Ausführungsform der erfindungsgemäßen Vorrichtung zur Erzeugung eines phasenverschobenen Signals;
- Fig. 2: eine schematische Erläuterung des Ausleseverfahrens bei der digitalen Signalerzeugung;
- Fig. 3: eine schematische Darstellung eines vereinfachten Widerstandsnetzwerks, das als Digital-Analog-Wandler arbeitet;
- Fig. 4: eine schematische Darstellung eines optoelektronischen Entfernungsmessers; und
- Fig. 5: einen beispielhaften Referenz- und Sendemustersignalverlauf.

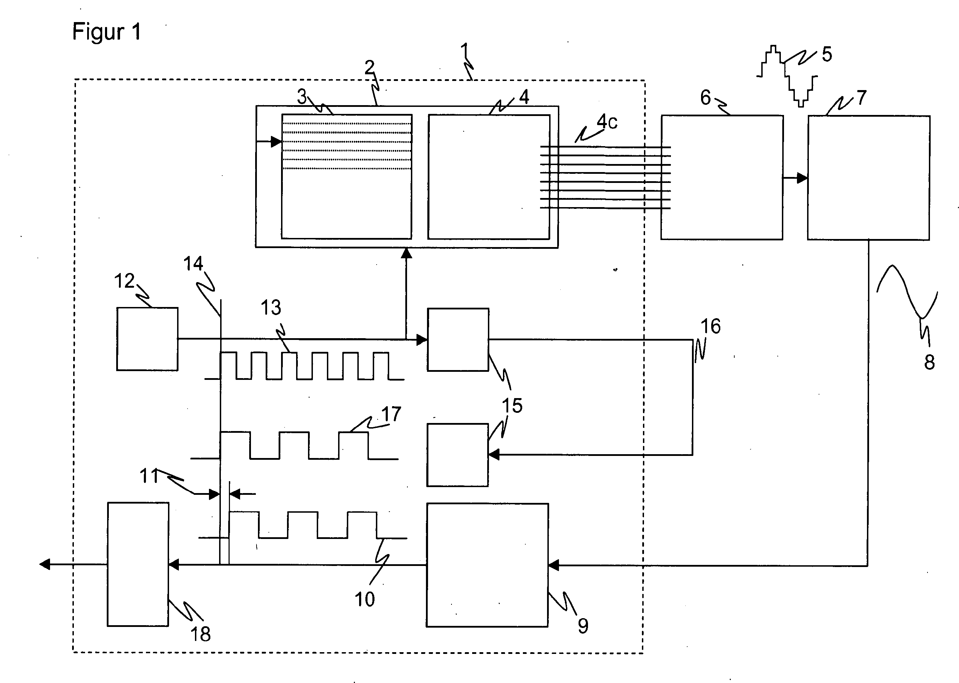

Figur 1 zeigt eine Ausführungsform der erfindungsgemäßen Vorrichtung zur Erzeugung eines phasenverschobenen Signals. Auf einem gemeinsamen programmierbaren Baustein 1, vorzugsweise ein PLD (Programmable Logic Device) oder ein FPGA (Field Programmable Gate Array), befindet sich eine Direkte-Digitale-Synthese-Einrichtung (DDS) 2. Als DDS-Einrichtung 2 ist hier nur derjenige digitale Bestandteil für die direkte digitale Synthese bezeichnet, der auf dem Baustein 1 implementiert ist, d.h. der digitale Werte als Repräsentation des Signals zur Verfügung stellt, nicht schon das (analoge) Signal selbst.

Die DDS-Einrichtung 2 weist einen Speicher 3 auf, in dem eine Wertetabelle abgelegt ist. Der Speicher 3 ist vorzugsweise ein nichtflüchtiges PROM. In jeder Zeile der Wertetabelle des Speichers 3 steht ein Tabellenwert für eine Phase des zu erzeugenden Signalmusters, das vorzugsweise eine Sinusschwingung ist.

Auf den Speicher 3 greift ein Signalgenerator 4 der DDS-Einrichtung 2 zu. Dieser liest den Tabellenwert einer Zeile der Wertetabelle ein und generiert digitale Spannungswerte für ein periodisches Signalmuster mit einer dem Tabellenwert entsprechenden Phasenlage. Dabei wird die Auswahl der Zeile von einer nicht dargestellten Steuerung vorgegeben.

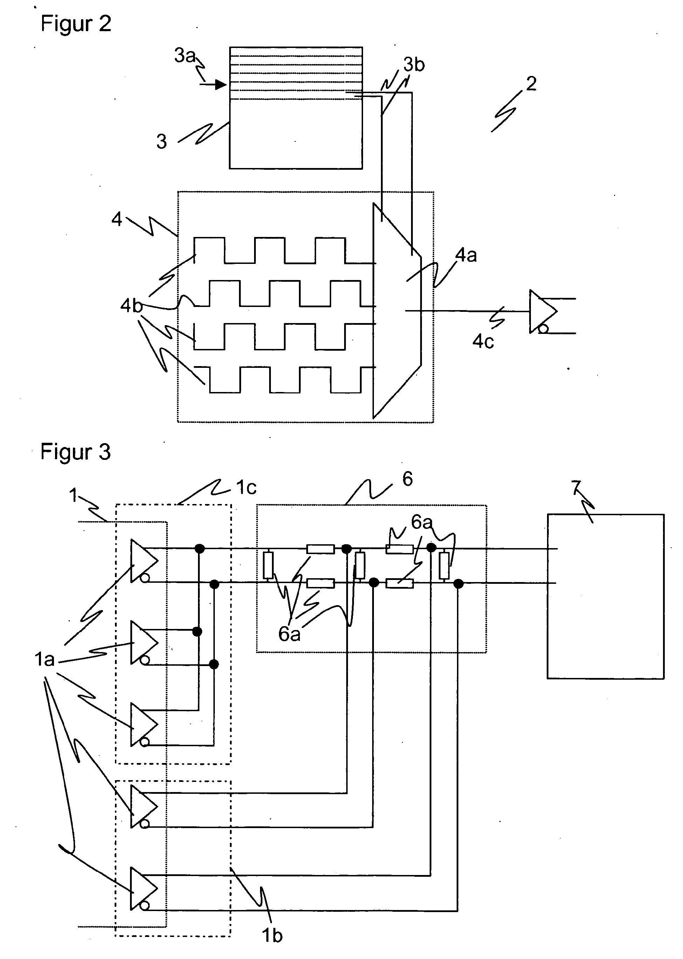

Das derart erzeugte periodische Signalmuster wird von dem Signalgenerator 4 als digitale Ausgabewerte für eine Stufenfunktion an Bitausgänge des Bausteins 1 gelegt. Die Breite dieser Stufenfunktion entspricht der Abtastrate, mit welcher der Signalgenerator 4 digitale Amplitudenwerte ausgeben kann. Diese Abtastrate ist zunächst durch die Arbeitsfrequenz des Bausteins 1 begrenzt. Liegt diese Arbeitsfrequenz bei 100 MHz, eine für PLD/FPGA übliche Größe, so können also derart nur 10ns als kleinste Zeiteinheit aufgelöst werden. Im Zusammenhang mit Fig. 2 wird erläutert, wie eine vierfach schnellere Zeitauflösung erreicht werden kann.

Es ist wichtig zu betonen, dass die Phasenunterschiede der durch die Tabellenwerte repräsentierten Phasen, die in den Zeilen der Tabelle 3 abgelegt sind, auch an diese vierfach schnellere Abtastrate nicht gebunden sind. Der Phasenunterschied zwischen den Zeilen beträgt im Gegenteil nur 100ps; die erste Zeile ist also nicht phasenverschoben, die zweite um 100ps, die dritte um 200ps usw. Diese Zahlen sind natürlich nur als Beispiel zu verstehen, genauso wie die Zuordnung einer Phase zu einer Zeile der Tabelle 3 nicht in dem angegebenen gleichmäßigen Inkrement erfolgen muss, sondern anwendungsspezifisch zu wählen ist.

Wegen der höheren Signalgenauigkeit ist jeder Bitausgang differentiell ausgelegt. Die Bitausgänge werden über ein Widerstandsnetzwerk 6 entsprechend ihrer Wertigkeit gewichtet. Das Widerstandsnetzwerk 6 arbeitet also mit den Strömen der Bitausgänge des Bausteins 1 als Treiber als sehr einfach zu realisierender und kostengünstiger Digital-Analog-Wandler 6, welcher die digitalen Werte an Ausgängen 4c des Signalgenerators 4 in ein analoges Stufensignal 5 konvertiert. Die Darstellung des Stufensignals 5 ist nur schematisch zu verstehen; die eigentliche Zahl der Stufen weicht hiervon ab und wird durch die Abtast- bzw. Ausgaberate an den Ausgängen 4c vorgegeben. Der Digital-Analog-Wandler 6 wird im Zusammenhang mit Figur 3 noch näher erläutert.

Dieses analoge Signal 5 wird dann einem unmittelbar nachgeschalteten Filter 7 zugeführt, der die Stufen glättet, also beispielsweise einem entsprechenden Tiefpass. Damit entsteht ein glattes, analoges, periodisches Signal 8, das die gewünschte Phasenlage entsprechend dem Tabellenwert der gewählten Zeile in der Tabelle 3 hat.

Dieses analog geglättete Signal 8 wird über einen Eingang des Bausteins 1 einem A/D-Wandler 9 des Bausteins 1 zugeführt. Hier genügt ein Binarisierer, der ein dem zugeführten Signal phasengleiches Rechtecksignal 10 erzeugt.

Das Rechtecksignal 10 mit seiner auf 100ps genauen Phase 11 kann nunmehr für nachgelagerte Funktionen verwendet werden, wie nachher noch beschrieben wird.

Um eine Laufzeitmessung vornehmen zu können, weist der Baustein 1 einen Taktgeber 12 auf, zu dessen Takt 13 von der nicht dargestellten Steuerung synchron ein Startsignal oder ein Referenzzeitpunkt 14 vorgegeben wird. Der Referenzzeitpunkt 14 triggert zum einen wie soeben erläutert die Erzeugung des phasenverschobenen Rechtecksignals 11 für den Messpfad. Zugleich wird der Referenzzeitpunkt 14 einem Referenzsignalgenerator 15 in einem Referenzpfad zugeführt. Dieser Referenzsignalgenerator 15 ist zweigeteilt dargestellt, weil je nach Ausführungsform ihm vor- oder nachgeschaltet eine Leerschleife 16 vorgesehen ist, die aus dem Baustein 1 heraus- und anschließend ohne weitere Signalverarbeitung wieder hineingeführt wird. Die Leerschleife 16 dient dem Fehlerausgleich, d.h. Temperaturabhängigkeiten, die im Messpfad durch die Aus- und Eingänge des Bausteins 1 und die internen Laufzeiten entstehen, werden zumindest zum Teil kompensiert. Damit ist die Temperaturstabilität der Vorrichtung deutlich verbessert. Außerdem kann der interne Signalweg in den Pfaden einander angeglichen werden.

Somit gibt der Referenzsignalgenerator synchron zum Referenzzeitpunkt ein Referenzsignal 17 aus. In der Figur 1 ist nicht dargestellt, ob sich das Referenzsignal 17 durch interne Laufzeiten gegenüber dem Takt 13 noch geringfügig verschiebt, da dies keine Rolle spielt, denn wegen der Kompensation ist jedenfalls das Rechtecksignal 10 relativ zum Referenzsignal 17 genau um die gewünschte Phase 11 verschoben.

Schließlich sind in einer bevorzugten Ausführungsform sämtliche noch verfügbaren unbenutzten, also nicht durch einen der beschriebenen Anschlüsse belegten Anschlüsse des Bausteins 1 als Ausgang konfiguriert und permanent mit externem Potential beschaltet, also mit der externen Masse oder Versorgungsspannung. Sie halten deshalb aktiv ihr Signal und verbinden somit die interne Spannungsversorgung durch die Vielzahl der parallelen Verbindungen niederohmig mit der externen Spannungsversorgung. Dadurch vermindert sich die störende gegenseitige Beeinflussung von Signalen durch Übersprechen innerhalb der Vorrichtung. Dieser Vorteil kann natürlich teilweise auch schon durch Beschaltung und Programmierung nicht sämtlicher, sondern nur einiger unbenutzter Anschlüsse erreicht werden.

Die beschriebene Vorrichtung ist demnach in der Lage, ein Referenzsignal und ein beispielsweise auf 100ps genau phasenverschobenes Rechtecksignal zu erzeugen, das noch mit einem Mustergenerator 18 zu einem gewünschten Sendemuster gefaltet werden kann. Diese feine Zeitauflösung gelingt mit dem einfachen Baustein 1, obwohl die eigentliche Abtastrate, mit der Amplitudenwerte an den Ausgängen des Bausteins 1 anliegen, wesentlich geringer ist.

Figur 2 erläutert die erfindungsgemäße Signalerzeugung einer digitalen Repräsentation der Stufenfunktion 5. Grundsätzlich wäre denkbar, in jeder Zeile der Tabelle 3 mehrere Amplitudenwerte zu äquidistanten Stützstellen einer Einzelperiode des zu erzeugenden Sinussignals abzulegen. Um die Phase festzulegen, genügen dafür bereits drei Amplitudenwerte. Der Speicherzugriff ist aber durch den einfachen Baustein 1 begrenzt, beispielsweise auf 100 MHz. Die Abtastrate, mit der die Amplitudenwerte an die Ausgänge des Bausteins 1 gelegt werden könnten, wäre für die geforderte zeitliche Präzision der Phase zu klein.

In der DDS-Einrichtung 2 ist daher ein anderes Verfahren implementiert. In der Tabelle 3 sind keine Amplitudenwerte, sondern in jeder Zeile ein die Phase repräsentierender Tabellenwert abgelegt. Dieser Tabellenwert hat die doppelte Anzahl Bits der geforderten Bitgenauigkeit, also beispielsweise 18 Bit für eine 9-Bit-Genau-igkeit. Um die Erklärung zu vereinfachen, ist in Figur 2 nur die Verarbeitung bei 1-Bit-Genauigkeit des Ausgangs illustriert.

In dem Signalgenerator 4 der DDS-Einrichtung 2 ist ein Multiplexer 4a vorgesehen. Auf die Dateneingänge des Multiplexers 4a wird ein 100 MHz-Takt des Bausteins 1 als vier Basissignale 4b um jeweils 90° phasenverschoben gelegt. Auf die beiden Selecteingänge des Multiplexers 4a wird ständig der 2-bittige Tabellenwert 3b gelegt. Der Tabellenwert 3a wird also nur einmal ganz zu Beginn aus dem Speicher 3 gelesen und liegt anschließend ständig an Select des Multiplexers 4a an. Die Auslesegeschwindigkeit des Speichers 3 spielt daher keine Rolle.

Damit gibt der Multiplexer 4a dasjenige um das entsprechende Vielfache von 90° verschobene Basissignal 4b aus, das in den beiden Bits 3b des Tabellenwerts codiert ist, denn diese beiden Bits 3b können die Phase nur auf 90° genau bestimmen.

Um nun eine höhere Bitgenauigkeit und damit eine feinere Phasenverschiebung zu erzielen, ist der dargestellte Signalgenerator 4 entsprechend vielfach ausgeführt, beispielsweise 9-fach für eine 9-Bit-Genauigkeit des Ausgangs. Jeweils 2 Bits 3b des 18-bittigen Tabellenwerts werden dann einem eigenen Multiplexer 4a zugeführt, auf dessen Dateneingängen die Basissignale 4b liegen. Damit liegen an den neun Ausgängen 4c der neun Multiplexer 4a die Amplitudenwerte als 9-Bit-Wert mit einer effektiven Abtastrate von 400 MHz an, obwohl der Speicher 3 einen derart schnellen Zugriff nicht erlaubt.

Es soll noch einmal betont werden, dass diese Erhöhung der Abtastrate um einen Faktor vier nur ein zusätzlich implementiertes Verfahren ist, um von dem noch langsameren Speicherzugriff unabhängig zu werden. Eine Phasengenauigkeit von 2,5ns, die mit 400 MHz erreichbar wäre, genügt für die erfindungsgemäß erreichte Zeitauflösung längst noch nicht. Die feine Zeitauflösung von beispielsweise 100ps wird erst von einer Vorrichtung erreicht, wie in Zusammenhang mit Figur 1 beschrieben.

Figur 3 erläutert anhand eines sehr vereinfachten Widerstandsnetzwerks 6, 6a, wie der Digital-Analog-Wandler 6 implementiert ist, der die gemäß Figur 2 von dem Signalgenerator 4 erzeugten digitalen Repräsentationen der zu erzeugenden Stufenfunktion in das analoge Stufensignal 5 umwandelt und zur anschließenden Glättung dem Filter 7 zuführt.

Das Widerstandsnetzwerk 6 besteht aus einer Vielzahl von Widerständen 6a, deren Aufgabe es ist, die anliegenden Ströme aus den beispielhaft dargestellten fünf Ausgängen 1a des Bausteins 1 entsprechend der Bitwertigkeit der Ausgänge 1a zu gewichten. Die Wahl der notwendigen Widerstandswerte 6a an sich für eine vorgegebene Gewichtung ist dem Fachmann geläufig. Die Kopplung von Baustein 1, Widerstandsnetzwerk 6 und Filter 7 ist differentiell ausgeführt, um die Signalstabilität zu erhöhen.

Damit nicht ein falsches Durchleiten eines hochwertigen Bits das gesamte Signal bis zur Unbrauchbarkeit verfälscht, sind nur die niedrigen Bits binär, die höherwertigen dagegen linear codiert:

In der in Figur 3 dargestellten Vereinfachung wird nur eine 4-Bit-Zahl ausgegeben. Die beiden niederwertigen Bits 1 b sind binär codiert, die beiden höherwertigen Bits 1c dagegen sind linear codiert, indem 3 Ausgänge zusammengeschaltet werden und somit ihr Signal mitteln. Sollte einer der 3 Ausgänge 1 c fehlerhaft sein, so trägt sein Fehler nur noch zu einem Drittel bei. Erst dieses gemittelte Signal geht dann in üblicher Weise ein, im Beispiel der beiden höchstwertigen Bits einer 4-Bit-Zahl mit einem Faktor von 3/4 (1/2 für das höchstwertige, 1/4 für das zweithöchstwertige Bit). Die beiden niederwertigen Bits 1b tragen in üblicher Binärcodierung mit einem Faktor 1/8 bzw. 1/16 bei. Diese Gewichtungen können durch Wahl der Widerstände 6a eingestellt werden.

Somit werden die Ströme an den LVDS-Stromausgängen 1a des Bausteins 1, die bestimmungsgemäß eigentlich einer digitalen Signalübertragung dienen, als Treiber des Digital-Analog-Wandlers 6 ausgenutzt. Die aktiven Bauteile des Digital-Analog-Wandlers sind somit über die Ausgänge des Bausteins 1, die passiven Bauteile als Widerstandsnetzwerk 6a außerhalb des Bausteins 1 realisiert.

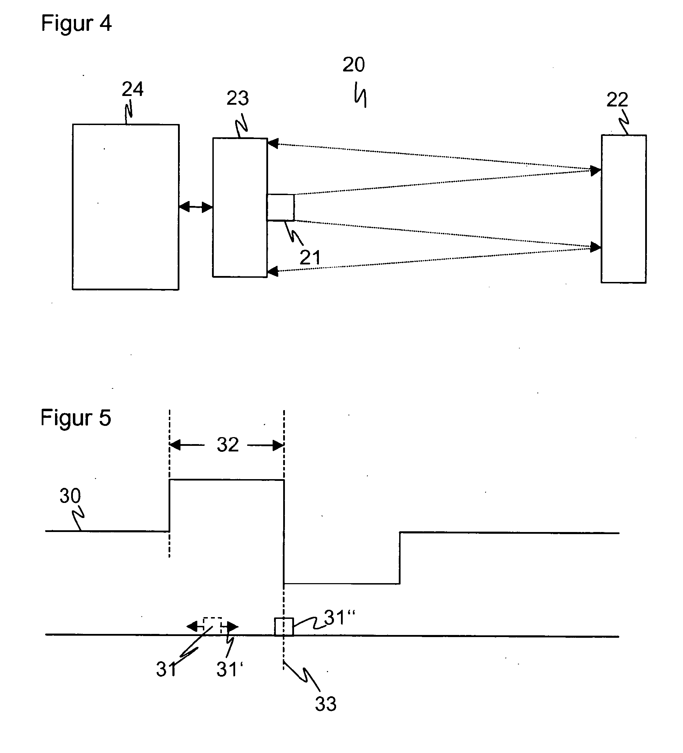

Figur 4 zeigt einen sehr vereinfacht dargestellten optoelektronischen Entfernungsmesser 20, in der die Vorrichtung eingesetzt werden kann. Die Anwendung in einem Entfernungsmesser 20 ist beispielhaft zu verstehen, die Erfindung ist darauf nicht beschränkt.

Der Entfernungsmesser 20 sendet über eine modulierbare Lichtquelle 21 einen Lichtstrahl zu einem Reflektor oder einem reflektierenden Zielobjekt 22. Der dort reflektierte Lichtstrahl kehrt zu einem Empfangselement 23 zurück, das die Lichtquelle 21 umgibt. Weil sich der Lichtstrahl auf seinem Weg aufweitet, verdeckt die Lichtquelle 21 nur einen kleinen und unerheblichen Teil des reflektierten Lichts. Natürlich kann man alternativ auch andere bekannten Lösungen einsetzen, wie einen Strahlteiler oder Pupillenteilung.

Die Vorrichtung gemäß Figur 1 ist Teil einer Steuerung 24 für Lichtquelle 21 und Empfangselement 23. Die Steuerung 24 ist in der Lage, ein elektrisches Signalmuster der Lichtquelle 21 als Intensitätsmodulation aufzuprägen, und umgekehrt konvertiert das Empfangselement 23 das empfangene reflektierte Licht zurück in das elektrische Signalmuster. Schließlich hat die Steuerung 24 noch eine nicht dargestellte Vergleichseinheit, um zu überprüfen, welches Vorzeichen die Phasenverschiebung zweier Signale hat, nämlich des Referenz- und des (wieder empfangenen) Sendesignals, oder ob sie gerade nicht gegeneinander phasenverschoben sind. Im Folgenden wird dieser Vergleich auch als Korrelation bezeichnet, obwohl andere Vergleichsverfahren möglich sind. Die Steuerung 24 mit ihren weiteren Elementen kann trotz dieser Darstellung auf dem Baustein 1 untergebracht sein, sofern dort noch Kapazitäten vorhanden sind.

Der Entfernungsmesser 20 kann nun sehr genau auf den erwarteten Abstand des Zielobjekts 22 eingelernt werden und erkennt dann, wenn dieses Zielobjekt 22 bewegt oder ein anderes spiegelndes Objekt eingeführt wird. Damit könnte der Entfernungsmesser 20 auch als Lichtschranke eingesetzt werden.

In einem Einlernvorgang wird zunächst die Entfernung des Zielobjekts 20 gelernt. Die grobe Entfernung kann durch geschickte, im Stand der Technik grundsätzlich bekannte Wahl von Sendemuster und Referenzsignal bestimmt werden. Das Prinzip lässt sich Figur 5 entnehmen. Dort ist oben ein einfaches Referenzsignal 30 aufgetragen, unten als gestricheltes Rechteck 31 dargestellt ein empfangenes Sendemuster in Form eines einfachen Pulses. Die Korrelation würde jetzt aufdecken, dass sich das empfangene Sendemuster 31 innerhalb des Bereichs 32 befindet. Genauer kann sie, wie die beiden Pfeile 31' in der Darstellung andeuten sollen, nicht sein. Dazu müsste das empfangene Sendemuster 31" gerade auf der Kante 33 liegen.

Ersetzt man das einfache Referenzsignal 30 und den Einzelpuls 31 durch kompliziertere, die über eine große Zeitspanne jeweils in jedem Bereich in eindeutiger Weise variieren, so lässt sich die Entfernung bis auf einen Bereich analog dem Bereich 32 bestimmen. Die dafür erforderliche genaue Ausgestaltung von Referenzsignal 30 und Sendemuster 31 ist nicht Gegenstand der Erfindung. Die noch fehlende Entfernungsauflösung innerhalb eines Bereiches 32, die erfindungsgemäß eingestellt werden kann, um genau eine Kante 33 zu erreichen, liegt dann innerhalb der Lichtlaufwege, die durch eine Einzelperiode abgedeckt sind, also die in der Vorrichtung gemäß Figur 1 einstellbare Phase.

Dazu werden nacheinander bei sonst festen Einstellungen die Zeilen der Tabelle durchgefahren und damit Sendemuster aller Phasen innerhalb einer Periode durchprobiert. Liegt der empfangene Sendepuls 31 bei der richtigen Phase mittig wie bei 31" dargestellt auf der Kante 33, so löscht er sich in der Korrelation durch einen halben positiven und einen halben negativen Anteil gerade aus. Diese Zeile oder diejenige, die einer Auslöschung am nächsten kommt, wird als Ergebnis des Einlernens gespeichert.

Im Betrieb wandert der Lichtpuls 31" entsprechend einer Bewegung des Zielobjekts 22 nach rechts oder links. Das schlägt sich sofort im Vorzeichen des Vergleichs zwischen Referenzsignal 30 und empfangenem Sendemuster 31 nieder, das durch die Bewegung nicht mehr auf der Kante 33 liegt, so dass der Entfernungsmesser 20 erkennt, in welcher Richtung das Zielobjekt 22 bewegt wurde, und er entsprechend etwa mit einem Warnsignal reagieren kann.

Ganz analog dem Einlernen kann auch eine Entfernungsbestimmung eines Objekts durchgeführt werden, welches Licht der Lichtquelle 21 reflektiert. Dazu wird erneut die grobe Entfernung anhand der Korrelation des geschickt gewählten Referenzsignals und des Sendemusters bestimmt. Anschließend wird wiederum die Phase bester Auslöschung in der Korrelation gesucht und daraus die Entfernung zurückgerechnet.

Insgesamt erreicht die Erfindung somit mit einfachen Mitteln eine sehr genaue Phase, die für eine entsprechend genaue Entfernungsmessung verwendet wird. Wenn die Muster im Referenz- und im Messkanal so angelegt sind, dass über deren Korrelation eine eindeutige Abstandsinformation ermittelt werden kann, so ist daraus die grobe Entfernung bereits bekannt und kann mit Hilfe der Phase auch fein gemessen werden. Der groberen Entfernungsmessung mittels erst über einen sehr großen Bereich periodischer Muster wird die nur innerhalb einer vergleichsweise kleinen 2π-Periode eindeutigen Messung durch die Phase als feine Entfernungsmessung überlagert. Dadurch ergibt sich einerseits eine sehr feine Zeitauflösung bei andererseits weitem Messbereich. So kann bei der beschriebenen Ausführungsform die Zeitauflösung lediglich 100ps über einen Bereich von mindestens 400ns betragen. Die erste Zahl von 100ps lässt sich prinzipiell durch Ablegen von mehr Tabellenwerten mit noch geringerer gegenseitiger Phasenverschiebung weiter verringern. Die zweite Zahl von 400ns hängt von der geschickten Wahl der Muster ab, die prinzipiell auch über noch größere Bereiche möglich ist.

### Bezugszeichen

- 1 -: Baustein (PLD/FPGA)
- 1a -: Ausgänge (des Bausteins)
- 1b -: Bits 0, 1 des Amplitudensignals
- 1c -: Bits 2, 3 des Amplitudensignals
- 2 -: Direkte-Digitale-Synthese-Einrichtung
- 3 -: Speicher (Tabelle)
- 3a -: gewählter Tabellenwert
- 3b -: Phaseninformation (nach Select)
- 4 -: Signalgenerator
- 4a -: Multiplexer
- 4b -: 90°-phasenverschobener Takt
- 4c -: Ausgang (Multiplexer)
- 5 -: digitales Stufensignal
- 6 -: DAC (Widerstandsnetzwerk)
- 6a -: Widerstände (des DAC)
- 7 -: Filter
- 8 -: geglättetes analoges Signal
- 9 -: Komparator (Binarisierer)
- 10 -: phasenverschobenes Rechtecksignal
- 11 -: Phase (des Rechtecksignals)
- 12 -: Taktgeber
- 13 -: Takt
- 14 -: Referenzzeitpunkt
- 15 -: Referenzsignalgenerator
- 16 -: Leerschleife
- 17 -: Referenzsignal
- 18 -: Mustergenerator
- 20 -: Entfernungsmesser
- 21 -: Lichtquelle
- 22 -: Reflektierendes Zielobjekt
- 23 -: Empfangselement
- 24 -: Steuerung
- 30 -: Referenzsignal
- 31,31',31": - Lichtpuls (Sendemuster)
- 32 -: Bereich (der groben Entfernungsbestimmung)
- 33 -: Kante (des Referenzmusters)

## Patentansprüche

1. Vorrichtung zur Erzeugung eines periodischen elektrischen Signals (8) mit vorgegebener Phasenverschiebung (11) gegenüber einem Referenzzeitpunkt (14), wobei die Vorrichtung folgendes aufweist:
- eine Direkte-Digitale-Synthese-Einrichtung (2), welche eine Tabelle (3) mit jeweils eine Phase repräsentierenden Tabellenwerten für das Signal (8) aufweist und welche daraus mittels eines Signalgenerators (4) das Signal mit einer Abtastrate je Amplitudenwert digital ausgeben kann,
- einen nachgeschalteten Digital-Analog-Wandler (6), und
- einen dem Digital-Analog-Wandler (6) nachgeschalteten Filter (7) zur Glättung des Signals (8),
**dadurch gekennzeichnet, dass**
die Tabellenwerte so gewählt sind, dass die jeweils vorgegebene Phasenverschiebung (11) zumindest für einen Teil der Tabellenwerte kleiner als die und/oder kein ganzzahliges Vielfaches der durch die Abtastrate vorgegebenen kleinsten Zeiteinheit ist, und dass somit die Phasenverschiebung (11) des Signals (8) durch Wahl des entsprechenden Tabellenwerts unabhängig von der Abtastrate vorgegeben werden kann
und dass alle Elemente, außer den passiven Bauteilen des Digital-Analog-Wandlers (6) und dem Filter (7), in einem programmierbaren Baustein (1) enthalten sind, insbesondere einem Field Programmable Gate Array oder einem Progammable Logic Device.

2. Vorrichtung nach Anspruch 1,
wobei ein dem Filter (7) nachgeschalteter Binarisierer (9) des Bausteins (1) dafür ausgebildet ist, das Signal (8) in eine phasengleiche Rechteckschwingung (10) umzuwandeln.

3. Vorrichtung nach Anspruch 2,
wobei ein Sendemustergenerator (18) des Bausteins (1) vorgesehen ist, der ein zu der Rechteckschwingung (10) phasengleiches Sendemustersignal (31) erzeugen kann.

4. Vorrichtung nach einem der vorhergehenden Ansprüche,
wobei ein Referenzsignalgenerator (15) des Bausteins (1) vorgesehen ist, der von dem Referenzzeitpunkt (14) ausgelöst ein Referenzsignal (17) erzeugen kann.

5. Vorrichtung nach Anspruch 4,
wobei eine Leerschleife (16) aus dem Baustein (1) geführt ist, über die der Referenzzeitpunkt (14) das Referenzsignal (17) auslöst.

6. Vorrichtung nach einem der vorhergehenden Ansprüche,
wobei der Signalgenerator (4) einen Multiplexer (4a) aufweist, an dessen Selecteingängen fest ein auf einem aus der Tabelle (3) ausgelesenen Wert basierendes Bitmuster anliegt und dessen Dateneingängen mit je einem um eine Phase verschobenen Takt (4b) des Logikbaussteins (1) verbunden sind, um somit auch die Abtastrate gegenüber einem Arbeitstakt des Bausteins 1 zu erhöhen.

7. Vorrichtung nach einem der vorhergehenden Ansprüche,
wobei alle oder höherwertige Ausgangsbits der Digitale-Synthese-Einrichtung (2) linear codiert sind.

8. Vorrichtung nach einem der vorhergehenden Ansprüche,
wobei der Digital-Analog-Wandler (6), der Filter (7) und der Baustein (1) differentiell, insbesondere zweikanalig gegenphasig gekoppelt und ausgeführt sind.

9. Vorrichtung nach einem der vorhergehenden Ansprüche,
wobei der Digital-Analog-Wandler (6) ein Widerstandsnetzwerk (6, 6a) aufweist, das von den Strömen der verbundenen Ausgänge des Bausteins (1) getrieben werden kann.

10. Vorrichtung nach einem der vorhergehenden Ansprüche,
wobei unbenutzte Anschlüsse des Bausteins (1) im Betrieb als Ausgang programmiert und mit externem Potential beschaltet sind.

11. Optoelektronischer Entfernungsmesser (20) mit einer Vorrichtung nach Anspruch 3 und einem der Ansprüche 4 bis 10,
wobei der Entfernungsmesser (20) mindestens eine modulierbare Lichtquelle (21), die für ein Aufprägen des Sendemustersignals auf das Sendelicht ausgebildet ist, sowie mindestens eine Empfangseinheit (23) für reflektiertes Sendelicht aufweist, die für ein Rückumwandeln des Sendemustersignals aus dem reflektierten Sendelicht ausgebildet ist,
wobei eine Vergleichseinheit (24) für das Erkennen einer gleichen Phasenlage und/oder des Vorzeichens einer abweichenden Phasenlage zwischen dem empfangenen Sendemustersignal (31) und dem Referenzsignal (30) ausgebildet ist.

12. Entfernungsmesser nach Anspruch 11,
wobei eine Phasenabgleichseinheit dafür ausgebildet ist, verschiedene Tabellenwerte der Tabelle (3) zu durchfahren, um diejenige Phasenverschiebung (11) zu finden, bei der die Vergleichseinheit (24) die beste Übereinstimmung der Phasenlage erkennt.

13. Entfernungsmesser nach Anspruch 12,
wobei die Tabelle (3) einen Speicher aufweist, in dem eine Information abgelegt werden kann, bei welchem der enthaltenen Tabellenwerte die Übereinstimmung der Phasenlage am besten ist.

14. Verfahren zur Erzeugung eines periodischen elektrischen Signals (8) mit vorgegebener Phasenverschiebung (11) gegenüber einem Referenzzeitpunkt (14), wobei das Verfahren folgende Schritte aufweist:
- Erzeugen des Signals (5) mittels direkter digitaler Synthese (2), indem aus einer Tabelle (3) ein eine Phase repräsentierender Tabellenwert ausgelesen und daraus das Signal mit einer Abtastrate je Amplitudenwert erzeugt und digital ausgegeben wird,
- Umwandlung des digitalen Signals in ein analoges Signal (5), und
- Glätten des analogen Signals,
**dadurch gekennzeichnet, dass**
die Tabellenwerte so gewählt sind, dass die jeweils vorgegebene Phasenverschiebung (11) zumindest für einen Teil der Tabellenwerte kleiner als die und/oder kein ganzzahliges Vielfaches der durch die Abtastrate vorgegebenen kleinsten Zeiteinheit ist, und dass somit die Phasenverschiebung (11) des Signals (8) durch Wahl des entsprechenden Tabellenwerts unabhängig von der Abtastrate vorgegeben wird und
dass das Verfahren auf einem programmierbaren Baustein (1) implementiert wird, insbesondere einem Field Programmable Gate Array oder einem Progammable Logic Device.

15. Verfahren nach Anspruch 14,
wobei das geglättete Signal (8) in eine phasengleiche Rechteckschwingung (10) umgewandelt wird.

16. Verfahren nach Anspruch 15,
wobei die Rechteckschwingung (10) in ein phasengleiches Sendemustersignal umgewandelt wird.

17. Verfahren zur Bestimmung der Entfernung eines reflektierenden Objekts (22), wobei die Lichtlaufzeit von dem Objekt (22) reflektierten Lichts einer Lichtquelle (21) gemessen wird, wobei
- über die Lichtquelle (21) ein Sendemustersignal gemäß Anspruch 16 ausgesandt wird,
- das empfangene Sendemustersignal (31) aus dem reflektierten Licht zurückgewonnen wird,
- das empfangene Sendemustersignal (31) mit einem zum Referenzzeitpunkt (14) synchronen Referenzsignal (30) verglichen wird und
- eine gleiche Phasenlage und /oder das Vorzeichen einer abweichenden Phasenlage zwischen dem empfangenen Sendemustersignal (31) und dem Referenzsignal (30) erkannt wird.

18. Verfahren nach Anspruch 17,
wobei eine gleiche Phasenlage als unveränderte Entfernung zu dem Objekt und ein positives bzw. negatives Vorzeichen einer abweichenden Phasenlage als verkürzte bzw. verlängerte Entfernung zu dem Objekt interpretiert wird.

19. Verfahren nach Anspruch 17,
wobei die Tabellenwerte der Tabelle (3) und damit die Phasen des Sendemustersignals bis zu einer bestmöglichen Übereinstimmung der Phasenlage zwischen empfangenem Sendemustersignal (31) und Referenzsignal (30) durchgefahren werden.

20. Verfahren nach Anspruch 19,
wobei die bestmögliche Übereinstimmung ausgenutzt wird, um die Entfernung eines Referenzobjekts zu lernen oder die Entfernung eines Objekts (22) zu bestimmen.

## Claims

1. An apparatus for the generation of a periodic electrical signal (8) with preset phase shift (11) with respect to a reference time (14),
wherein the apparatus comprises the following:
- a direct digital synthesis device (2) which has a table (3) having table values for the signal (8) respectively representing a phase and which can output the signal therefrom digitally with a sampling rate per amplitude value by means of a signal generator (4);
- a downstream digital to analog converter (6); and
- a filter (7) downstream of the digital to analog converter (6) for the smoothing of the signal (8),
**characterized in that**
the table values are selected such that the respective preset phase shift (11) is smaller than the smallest time unit preset by the sample rate and/or no not an integral multiple of the smallest time unit preset by the sampling rate, at least for some of the table values; and **in that** the phase shift (11) of the signal (8) can thus be preset independently of the sampling rate by selection of the corresponding table value;
and **in that** all the elements, except for the passive components of the digital to analog converter (6) and the filter (7), are included in a programmable module (1), in particular in a field programmable gate array or in a programmable logic device.

2. An apparatus in accordance with claim 1, wherein a binarizer (9) of the module (1) downstream of the filter (7) is made to convert the signal (8) into an in-phase square wave (10) .

3. An apparatus in accordance with claim 2, wherein a transmission pattern generator (18) of the module (1) is provided which can generate a transmission pattern signal (31) in phase with the square wave (10) .

4. An apparatus in accordance with any one of the preceding claims, wherein a reference signal generator (15) of the module (1) is provided which can generate a reference signal (17), triggered by the reference time (14).

5. An apparatus in accordance with claim 4, wherein an empty loop (16) is guided out of the module (1) and the reference time (14) triggers the reference signal (17) via it.

6. An apparatus in accordance with any one of the preceding claims, wherein the signal generator (4) has a multiplexer (4a) at whose select inputs a bit pattern based on a value read out of the table (3) is fixedly applied and whose data inputs are connected with a respective one cycle (4b) of the logic component (1) shifted by a phase in order thus also to increase the sampling rate with respect to a work cycle of the module 1.

7. An apparatus in accordance with any one of the preceding claims, wherein all the output bits or the higher value output bits of the digital synthesis device (2) are linear encoded.

8. An apparatus in accordance with any one of the preceding claims, wherein the digital to analog converter (6), the filter (7) and the module (1) are coupled and made differentially, in particular with two channels and out of phase.

9. An apparatus in accordance with any one of the preceding claims, wherein the digital to analog converter (6) has a resistance network (6, 6a) which can be driven by the currents of the connected outputs of the module (1).

10. An apparatus in accordance with any one of the preceding claims, wherein unused connections of the module (1) are programmed as outputs and are connected to external potential in operation.

11. An optoelectronic distance measuring device (20) having an apparatus in accordance with claim 3 and any one of the claims 4 to 10,
wherein the distance measurement device (20) has at least one modulable light source (21) which is made for an imposition of the transmission pattern signal onto the transmission light as well as at least one receiver unit (23) for reflected transmission light which is made for a reverse conversion of the transmission pattern signal from the reflected transmission light,
wherein a comparator unit (24) is made for the recognition of a like phasing and/or of the sign of a different phasing between the received transmission pattern signal (31) and the reference signal (30).

12. A distance measurement device in accordance with claim 11,
wherein a phase comparator unit is made to move through different table values of the table (3) to find that phase shift (11) at which the comparator unit (24) recognizes the best coincidence of the phasing.

13. A distance measurement device in accordance with claim 12, wherein the table (3) has a memory in which information can be stored at which of the included table values the coincidence of the phasing is best.

14. A method for the generation of a periodic electrical signal (8) with a preset phase shift (11) with respect to a reference time (14), wherein the method comprises the following steps:
- generation of the signal (5) by means of direct digital synthesis (2) in that a table value representing a phase is read out of a table (3) and the signal is generated from it with a sampling rate per amplitude value and is output digitally;
- conversion of the digital signal into an analog signal (5); and - smoothing of the analog signal,
**characterized in that**
the table values are selected such that the respective preset phase shift (11) is smaller than the and/or no whole-number multiple of the smallest time unit preset by the sampling rate at least for some of the table values and that the phase shift (11) of the signal (8) can thus be preset independently of the sampling rate by selection of the corresponding table value; and
**in that** the method is implemented on a programmable module (1), in particular a field programmable gate array or a programmable logic device.

15. A method in accordance with claim 14, wherein the smoothed signal (8) is converted into an in-phase square wave (10).

16. A method in accordance with claim 15, wherein the square wave (10) is converted into an in-phase transmission pattern signal.

17. A method for the determination of the distance of a reflecting object (22), wherein the time of flight of light of light of a light source (21) reflected by the object (22) is measured, wherein
- a transmission pattern signal in accordance with claim 16 is transmitted via the light source (21);
- the received transmission pattern signal (31) is recovered from the reflected light;
- the received transmission sample signal (31) is compared with a reference signal (30) synchronous with the reference time (14); and
- a like phasing and/or the sign of a differing phasing between the received transmission pattern signal (31) and the reference signal (30) is recognized.

18. A method in accordance with claim 17, wherein a like phasing is interpreted as an unchanged distance from the object and a positive or negative sign of a differing phasing is interpreted as a shortened or extended distance from the object.

19. A method in accordance with claim 17, wherein the table values of the table (3), and thus the phases of the transmission pattern signal, are moved through up to a best possible coincidence of the phasing between the received transmission pattern signal (31) and the reference signal (30).

20. A method in accordance with claim 19, wherein the best possible coincidence is utilized to teach the distance of a reference object or to determine the distance of an object (22).

## Revendications

1. Dispositif de production d'un signal électrique périodique (8) avec un déphasage (11) prédéterminé par rapport à un instant de référence (14), le dispositif comprenant :
- un dispositif de synthèse numérique directe (2) qui comporte un tableau (3) avec différentes valeurs tabulaires représentant chacune une phase pour le signal (8) et qui peut à partir de là produire le signal sous forme numérique, à l'aide d'un générateur de signaux (4), avec un débit d'échantillonnage en fonction de l'amplitude,
- un convertisseur numérique-analogique (6) monté en aval, et
- un filtre (7) monté en aval du convertisseur numérique-analogique (6) afin de lisser le signal,
**caractérisé en ce que**
les valeurs tabulaires sont sélectionnées de manière à ce que les différents déphasages (11) prédéterminés soient, au moins pour une partie des valeurs tabulaires, inférieurs à l'unité de temps minimale prédéterminée par le débit d'échantillonnage et/ou n'en soient pas un multiple entier et à ce que, de cette manière, le déphasage (11) du signal (8) puisse être prédéterminé par la sélection d'une valeur tabulaire correspondante, indépendamment du débit d'échantillonnage, et
**en ce que** tous les éléments, en dehors des composants passifs du convertisseur numérique-analogique (6) et en dehors du filtre (7), sont regroupés dans un composant programmable (1), en particulier dans un réseau prédiffusé programmable in situ (« *Field-Programmable Gate Array* ») ou dans un dispositif logique programmable (« *Programmable Logic Device*»).

2. Dispositif selon la revendication 1, dans lequel un binarisateur (9) du composant (1) monté en aval du filtre (7) est conçu pour convertir le signal (8) en une oscillation carrée (10) de même phase.

3. Dispositif selon la revendication 2, dans lequel il est prévu un générateur de motif d'émission (18) du composant (1), qui peut produire un signal de motif d'émission ayant la même phase que l'oscillation carrée (10).

4. Dispositif selon l'une des revendications précédentes, dans lequel il est prévu un générateur de signal de référence (15) du composant (1) qui peut produire un signal de référence (17), déclenché par l'instant de référence (14).

5. Dispositif selon la revendication 4, dans lequel le composant (1) exécute une boucle vide (16), grâce à laquelle l'instant de référence (14) déclenche le signal de référence (17).

6. Dispositif selon l'une des revendications précédentes, dans lequel le générateur de signal (4) comporte un multiplexeur (4a) sur les entrées de sélection duquel est appliqué de manière constante un motif binaire fondé sur une valeur lue dans le tableau (3) et dont les entrées de données sont reliées à un signal d'horloge (4b) décalé d'une phase du composant logique (1) afin d'augmenter ainsi aussi le débit d'échantillonnage par rapport à une fréquence de travail du composant (1).

7. Dispositif selon l'une des revendications précédentes, dans lequel sont codés de manière linéaire tous les bits de sortie ou les bits de poids élevé du dispositif de synthèse numérique (2).

8. Dispositif selon l'une des revendications précédentes, dans lequel le convertisseur numérique-analogique (6), le filtre (7) et le composant (1) sont conçus de manière différentielle, en particulier couplés par deux canaux de phase opposée.

9. Dispositif selon l'une des revendications précédentes, dans lequel le convertisseur numérique-analogique (6) possède un réseau de résistances (6, 6a) qui peut être attaqué par les courants des sorties reliées du composant (1) .

10. Dispositif selon l'une des revendications précédentes, dans lequel des raccordements inutilisés du composant (1) sont programmés en service comme des sorties et sont mis en circuit avec un potentiel extérieur.

11. Télémètre optoélectronique (20) avec un dispositif selon la revendication 3 et selon l'une des revendications 4 à 10, lequel télémètre (20) comporte au moins une source lumineuse (21) modulable, qui est conçue pour placer le signal de motif d'émission sur la lumière émise, ainsi qu'au moins une unité de réception (23) pour recevoir la réflexion de la lumière émise, qui est conçue pour reconvertir le signal du motif d'émission à partir de la réflexion de la lumière émise, dans lequel une unité de comparaison (24) est conçue pour détecter une relation des phases identique et/ou le signe d'une relation des phases entre le signal de motif d'émission reçu (31) et le signal de référence (30).

12. Télémètre selon la revendication 11, dans lequel une unité d'égalisation de phase est conçue pour consulter plusieurs valeurs du tableau (3) afin de trouver le déphasage (11) pour lequel l'unité de comparaison (24) trouve la meilleure concordance de la relation des phases.

13. Télémètre selon la revendication 12, dans lequel le tableau (3) possède une mémoire dans laquelle peut être stockée une information indiquant celle des valeurs stockées dans le tableau qui fournit la meilleure concordance de la relation des phases.

14. Procédé de production d'un signal électrique périodique (8) avec un déphasage (11) prédéterminé par rapport à un instant de référence (14), le procédé comprenant les étapes consistant à :
- produire le signal (5) par une synthèse numérique directe (2) en lisant dans un tableau (3) une valeur tabulaire représentant une phase, en produisant sur cette base le signal avec un débit d'échantillonnage en fonction de l'amplitude et en le produisant en sortie sous forme numérique,
- convertir le signal numérique en signal analogique (5), et
- lisser le signal analogique,
**caractérisé en ce que**
les valeurs tabulaires sont sélectionnées de manière à ce que les différents déphasages (11) prédéterminés soient, au moins pour une partie des valeurs du tableau, inférieurs à l'unité de temps minimale prédéterminée par le débit d'échantillonnage et/ou n'en soient pas un multiple entier et à ce que, de cette manière, le déphasage (11) du signal (8) puisse être prédéterminé par la sélection d'une valeur tabulaire correspondante, indépendamment du débit d'échantillonnage, et
**en ce que** le procédé est mis en oeuvre sur un composant programmable (1), en particulier un réseau prédiffusé programmable in situ (« *Field-Programmable Gate Array* ») ou un dispositif logique programmable (« *Programmable Logic Device*»).

15. Procédé selon la revendication 14, dans lequel le signal lissé (8) est converti en une oscillation carrée (10) de même phase.

16. Procédé selon la revendication 15, dans lequel l'oscillation carrée (10) est convertie en un signal de motif d'émission de même phase.

17. Procédé de détermination de la distance d'un objet réfléchissant (22), dans lequel est mesurée la durée de parcours de la lumière provenant d'une source lumineuse (21) et réfléchie par l'objet (22), dans lequel
- la source lumineuse (21) émet un signal de motif d'émission selon la revendication 16,
- le signal de motif d'émission (31) reçu est extrait de la lumière réfléchie,
- le signal de motif d'émission (31) reçu est comparé à un signal de référence (30) synchronisé avec l'instant de référence (14), et
- une relation de phases identique et/ou le signe d'une relation de phases est déterminé entre le signal de motif d'émission (31) reçu et le signal de référence (30).

18. Procédé selon la revendication 17, dans lequel une relation de phases identique est interprétée comme une distance inchangée de l'objet tandis qu'un signe positif ou négatif est interprété comme une réduction ou une augmentation de la distance de l'objet.

19. Procédé selon la revendication 17, dans lequel les valeurs tabulaires du tableau (3), et ainsi les phases du signal de motif d'émission, sont parcourues jusqu'à trouver la meilleure concordance de la relation de phases possible entre le signal de motif d'émission (31) reçu et le signal de référence (30).

20. Procédé selon la revendication 19, dans lequel la meilleure concordance possible est utilisée pour apprendre la distance d'un objet de référence ou pour déterminer la distance d'un objet (22).
